# DEMANDE DE BREVET EUROPEEN

(11) **EP 4 801 223 A1**
(43) Date de publication de la demande: **02.09.2026**
(21) Numéro de dépôt: 26159650.6
(22) Date de dépôt: 19.02.2026
(51) Int. Cl.: H10D 64/01, H10D 62/85

(54) **RÉALISATION DE CONTACT OHMIQUE AMELIORÉ SUR UNE COUCHE À BASE DE GAN**

(30) Priorité: 26.02.2025 FR 2501959
(71) Demandeur: Commissariat à l'Energie Atomique et aux Energies Alternatives, 75015 Paris (FR)
(72) Inventeur: GUILLEMIN, Sophie, 38054 Grenoble Cedex 09 (FR); COIG, Marianne, 38054 Grenoble Cedex 09 (FR); XU, Laurent, 38054 Grenoble Cedex 09 (FR)
(74) Mandataire: Santarelli

(57) **Abrégé**

Procédé de réalisation d'un contact ohmique sur une couche semi-conductrice (14) à base de GaN dopée p comprenant, dans cet ordre, les étapes suivantes :
-prévoir un substrat (10) se terminant par une couche semi-conductrice à base de GaN (14),
-effectuer au moins une implantation de la couche semi-conductrice (14) à l'aide de Magnésium (Mg) de sorte à introduire des atomes de Mg dans la couche semi-conductrice (14) et de manière à rendre amorphe une région superficielle (142) de la couche semi-conductrice (14), tout en conservant une région inférieure (141) cristalline de la couche semi-conductrice,
-déposer une première couche métallique (17) sur et en contact de la région superficielle (142) rendue amorphe de la couche semi-conductrice (14),
-effectuer au moins un traitement thermique de recuit selon une température et une durée de recuit prévues de manière à faire réagir la région superficielle (142) et la première couche métallique (17) pour former une zone d'alliage de métal et de semi-conducteur et former entre cette zone d'alliage de métal et de semi-conducteur et la région inférieure cristalline de la couche semi-conductrice une couche delta comportant des atomes de Magnésium.

## Description

### DOMAINE TECHNIQUE ET ÉTAT DE LA TECHNIQUE ANTÉRIEURE

La présente demande concerne le domaine des dispositifs semi-conducteurs à base de GaN, et en particulier la réalisation de contacts ohmiques sur des zones semi-conductrices à base de GaN et dopées P.

Les matériaux semi-conducteurs à base de nitrure de gallium (GaN) tels que le GaN lui-même, ou l'InGaN, ou l'AlGaN trouvent de nombreuses applications dans l'optoélectronique ou la microélectronique. L'utilisation de ces matériaux dans les composants d'électronique de puissance s'avère particulièrement avantageuse.

Par ailleurs, l'établissement d'un contact ohmique sur une surface semi-conductrice à base de nitrure de gallium (GaN) est difficile. Cela réside notamment dans le fait que le GaN a une forte tendance à s'oxyder en surface et qu'une fois un oxyde formé, cet oxyde s'avère difficile à retirer. Actuellement, les performances des contacts sur GaN restent bien inférieures à celles des contacts mis en œuvre sur silicium. La réalisation de contacts ohmiques sur les matériaux à base de nitrure de gallium et qui sont dopés P tels que le p-GaN s'avère encore plus difficile que sur les matériaux à base de nitrure de gallium et qui sont dopés N tels que le n-GaN.

Pour former un contact ohmique sur une couche de GaN, on dépose typiquement une ou plusieurs couches de métaux sur cette couche puis on effectue un recuit. Le choix des métaux est généralement dicté par les contraintes technologiques (typiquement, la nécessité ou non de ne pas inclure de métaux dits nobles tels que Au ou Pt dans l'empilement technologique) ainsi que leurs propriétés intrinsèques telles que la valeur du travail de sortie qui leur est associée.

Pour améliorer le contact il est parfois proposé d'ajouter, avant le dépôt métallique, une étape de dopage par implantation de la zone à contacter afin d'augmenter le niveau de dopage sous le contact et favoriser ainsi le passage des porteurs de charge par effet tunnel.

L'inconvénient d'une telle solution est qu'un recuit d'activation des dopants est ensuite généralement nécessaire et qu'un tel recuit se fait typiquement à plus de 1000 °C, autrement dit à un niveau de température incompatible avec de nombreuses technologies.

Un autre procédé permettant de réaliser un contact ohmique sur une région semi-conductrice à base de GaN et dopée P consiste à déposer une fine couche de Mg intermédiaire entre la région semi-conductrice à partir de laquelle on forme le contact et l'empilement métallique.

L'inconvénient d'une telle solution vient du fait que le magnésium est un matériau pyrophorique, ce qui pose des problèmes de sécurité et rend son dépôt proscrit au niveau industriel. Par ailleurs, une telle approche ne permet de résoudre le problème de la présence d'une couche native d'oxyde naturellement présente sur la région semi-conductrice à base de GaN et qui limite les performances du contact.

Il se pose donc le problème de trouver un nouveau procédé de réalisation d'un contact ohmique sur une couche semi-conductrice contenant du GaN et dopée P et qui soit amélioré vis-à-vis d'inconvénients énoncés ci-dessus.

### EXPOSÉ DE L'INVENTION

C'est par conséquent un but de la présente invention d'offrir un procédé de réalisation d'un contact ohmique sur une couche semi-conductrice à base de GaN comprenant, dans cet ordre, les étapes suivantes :
- prévoir un substrat revêtu de la couche semi-conductrice,
- effectuer au moins une implantation de la couche semi-conductrice à l'aide de Magnésium (Mg) de manière à endommager la structure cristalline d'une région superficielle de la couche semi-conductrice tout en conservant une région inférieure cristalline de la couche semi-conductrice,
- déposer une première couche métallique sur et en contact de la région superficielle endommagée de la couche semi-conductrice,
- effectuer au moins un traitement thermique de recuit selon une température et une durée de recuit prévues de manière à faire inter-diffuser les atomes de la première couche métallique et de la couche semi-conductrice pour former un alliage. Cet alliage est réalisé en consommant de préférence au minimum la région fortement endommagée de la couche semi-conductrice.

Un tel procédé présente plusieurs avantages. Tout d'abord, l'interface originelle entre la couche semi-conductrice et la première couche métallique est consommée lors des réactions à l'état solide mises en œuvre durant le recuit, permettant de redistribuer une éventuelle fine couche d'oxyde natif originellement présente à la surface de la couche semi-conductrice et donc de s'en affranchir.

Par ailleurs, un phénomène bien particulier a été observé par les inventeurs, i.e. les atomes de Mg implantés dans la couche semi-conductrice sont repoussés à l'interface inférieure du front de croissance de l'alliage métal/semi-conducteur. On se retrouve donc avec une configuration proche de procédés où une fine couche de Mg est déposée sur le semi-conducteur, mais sans les problèmes liés au dépôt massif de cette couche et sans les problématiques de préparation de surface.

Plus précisément, entre la zone d'alliage métal/semi-conducteur et la région inférieure cristalline de la couche semi-conductrice, une couche delta, autrement dit une fine couche comportant des atomes de Magnésium par exemple avec au moins 5% d'atomes de Magnésium, typiquement au moins 20% d'atomes de Magnésium est formée.

Cette fine couche a typiquement une épaisseur comprise entre de l'ordre de un ou plusieurs nanomètre(s) et plusieurs dizaines de nanomètres, par exemple entre 0.5 nm et 30 nm.

Un tel procédé, permet d'obtenir un contact ohmique de qualité améliorée sur une région à base de GaN dopée P.

La région superficielle dont la structure cristalline est endommagée lors de l'implantation est de préférence rendue quasi-amorphe ou amorphe.

Par « quasi-amorphe » on entend que la structure cristalline de la région superficielle présente des ruptures de la périodicité du réseau cristallin régulières, de type défauts ponctuels ou étendus, ainsi que des inclusions où l'ordre atomique est perdu sur une courte échelle atomique, par exemple de l'ordre de plusieurs nanomètres. La densité des défauts ponctuels ou étendus se traduit par un désordre relatif (nombre effectif de centres de diffusion, exprimé en pourcentage, un ordre absolu étant égal à 0 et un désordre absolu étant égal à 1) typiquement supérieur à 0.6 au pic d'endommagement. Le volume de la couche endommagée, où l'ordre atomique est complètement perdu, est quant à lui typiquement supérieur à 10 %.

Avantageusement, l'implantation de la couche semi-conductrice (14) est effectuée à une dose élevée et en particulier supérieure à 1E16 atomes/cm⁻² avec une énergie faible et en particulier inférieure à 4 keV.

De préférence, la région superficielle endommagée et rendue quasi-amorphe ou amorphe par ladite implantation a une épaisseur inférieure à 20 nm et qui peut être comprise entre 3 et 10 nm.

Avantageusement, la température de recuit peut être comprise entre 400°C et 600°C.

Selon une possibilité de mise en œuvre, pour un recuit effectué dans une telle gamme de température, la durée du recuit peut être prévue entre 15 s et 5 min en particulier pour des recuits de type « recuits rapides » ou entre 5 min et 30 min en particulier pour des recuits standards, avantageusement entre 30 s et 3 min.

Selon un mode de réalisation avantageux, la première couche métallique est une couche de Ti.

La première couche métallique peut être prévue avantageusement avec une épaisseur comprise entre 5 nm et 30 nm.

Cette première couche métallique peut être revêtue d'une autre couche métallique d'encapsulation, en particulier à base d'un métal oxydorésistant tel que du TiN.

Selon différents modes de réalisation, la couche semi-conductrice peut être formée d'un ou plusieurs des matériaux suivants : GaN ou d'AlGaN, ou d'InGaN.

Avantageusement, le procédé de réalisation d'un contact ohmique est dépourvu d'une étape de recuit effectuée entre l'étape d'implantation de la couche semi-conductrice à l'aide de Magnésium (Mg) de manière à endommager la structure cristalline de la région superficielle de la couche semi-conductrice et l'étape de dépôt de la première couche métallique. Ainsi, on offre un procédé plus rapide.

### BRÈVE DESCRIPTION DES DESSINS

La présente invention sera mieux comprise à la lecture de la description d'exemples de réalisation donnés, à titre purement indicatif et nullement limitatif, en faisant référence aux dessins annexés sur lesquels :

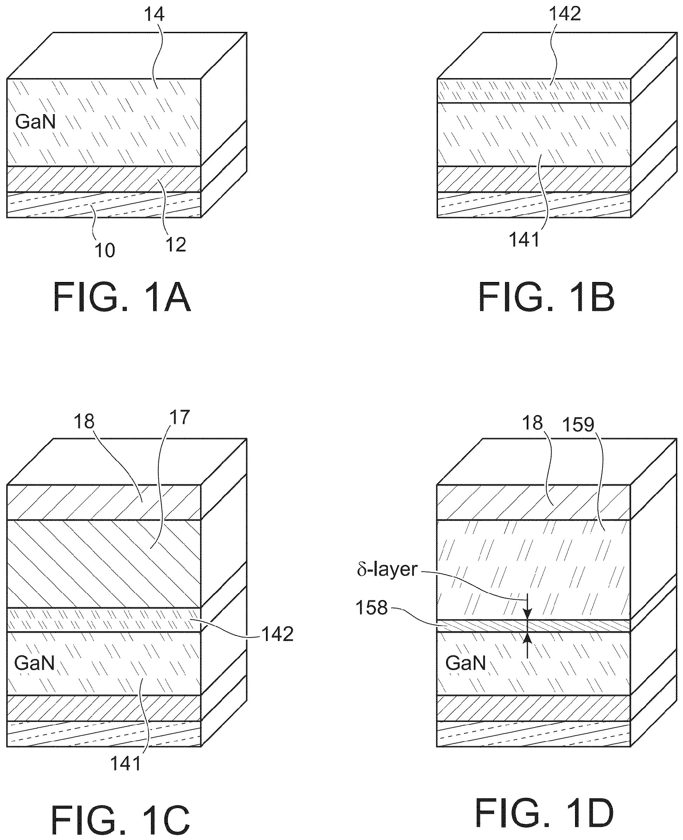

Les figures 1A, 1B, 1C et 1D servent à illustrer un exemple de procédé selon l'invention de réalisation d'un contact ohmique amélioré sur une région semi-conductrice à base de GaN et ayant un dopage de type p.

Des parties identiques, similaires ou équivalentes des différentes figures portent les mêmes références numériques de façon à faciliter le passage d'une figure à l'autre.

Les différentes parties représentées sur les figures ne le sont pas nécessairement selon une échelle uniforme, pour rendre les figures plus lisibles.

En outre, dans la description ci-après, des termes qui dépendent de l'orientation de la structure tels que « dessus », « dessous », « inférieur », « supérieur », « juxtaposé », « superposé », « vertical », « horizontal » s'appliquent en considérant que la structure est orientée de la façon illustrée sur les figures.

### EXPOSÉ DÉTAILLÉ DE MODES DE RÉALISATION PARTICULIERS

On se réfère à présent à la figure 1A qui représente schématiquement une structure semi-conductrice de départ possible pour la mise en œuvre d'un exemple de procédé, selon l'invention, de réalisation d'un contact ohmique amélioré sur une région semi-conductrice dopée p.

La couche semi-conductrice 14 sur laquelle on souhaite former le contact est en un matériau semi-conducteur III-V, en particulier à base de GaN, tel que par exemple du GaN ou de l'InGaN, ou de l'AlGaN.

Selon un mode de réalisation particulier, la couche semi-conductrice 14 peut être formée d'un empilement de matériaux semi-conducteurs distincts, par exemple d'une couche en GaN revêtue d'une fine couche d'InGaN.

La couche semi-conductrice 14 a une épaisseur qui peut être par exemple comprise entre 10 nm et 100 nm dans un cas particulier où le contact réalisé est celui d'un composant ou transistor d'un circuit optoélectronique ou entre 100 nm et plusieurs centaines de nanomètres dans un autre cas particulier où le contact réalisé est celui d'un composant ou transistor de puissance.

La couche semi-conductrice 14 peut être formée par épitaxie sur un substrat 10, ici par exemple en silicium, en particulier du Si [1 1 1]. D'autres modes de réalisation prévoient d'autres types de substrat, par exemple un substrat en Saphir ou en SiC. Dans le cas où la couche semi-conductrice 14 est réalisée par épitaxie, une couche tampon 12 intermédiaire entre le substrat 10 et la couche semi-conductrice 14 est typiquement prévue pour réaliser une adaptation du paramètre de maille avec le substrat 10. La couche tampon 12 peut être par exemple formée d'un empilement à base d'AIN et d'AlGaN avec un gradient de concentration en Aluminium.

La couche semi-conductrice 14 peut être une couche non-dopée ou non intentionnellement dopée lors de la croissance épitaxiale. D'autres modes de réalisation prévoient une couche semi-conductrice 14 dopée par implantation ionique après avoir effectué la croissance épitaxiale à l'aide d'une espèce tel que du magnésium (Mg). Cette implantation est alors suivie d'un recuit d'activation des dopants.

A partir de la structure précitée, on réalise tout d'abord (figure 1B) un endommagement de préférence important de la structure cristalline d'une région superficielle 142 de la couche semi-conductrice 14 tout en conservant une région inférieure 141 cristalline. Cet endommagement est réalisé ici à l'aide d'au moins une étape d'implantation ionique en utilisant du Magnésium (Mg).

La région superficielle 142 endommagée est rendue amorphe ou quasi-amorphe est de préférence prévue suffisamment fine pour pouvoir être ensuite consommée entièrement lors d'une étape ultérieure de formation d'alliage métal/semi-conducteur. Typiquement, la région superficielle 141 est prévue avec une épaisseur inférieure à 20 nm et qui peut être comprise par exemple entre 3 nm et 10 nm.

Pour obtenir une région superficielle 142 endommagée aussi fine on prévoit de préférence une faible énergie d'implantation, en particulier inférieure à 4 keV et par exemple typiquement comprise entre 1 keV et 10 keV.

Pour permettre d'obtenir dans le même temps un niveau d'endommagement de la région superficielle 142 élevé, ainsi que la présence dans la structure d'une quantité importante d'atomes de Mg, on prévoit de préférence une dose d'implantation élevée, ici par exemple supérieure à 1E16 at/cm². La dose d'implantation d'ions Mg+ peut être par exemple choisie entre 1E16 et 5E17 atomes/cm².

Dans un exemple de réalisation particulier où l'on implante une région superficielle 142 d'épaisseur de l'ordre de 10 nm d'une couche semi-conductrice 14 de GaN, l'énergie d'implantation peut être prévue par exemple de l'ordre de 4 keV et la dose d'implantation par exemple de l'ordre de 1E16 atomes/cm².

A l'issue de l'étape d'implantation on obtient typiquement une région superficielle amorphe ou quasi-amorphe et riche en espèce implantée disposée sur une région inférieure 141 cristalline, dont l'épaisseur est par exemple comprise entre 3 nm et 10 nm.

Le procédé comprend ensuite une étape de dépôt d'une couche métallique 17 sur et en contact de la région supérieure 142 rendue quasi-amorphe de la couche semi-conductrice 14. La couche métallique 17 est de préférence formée à base d'un métal compatible en matière de contamination avec un environnement de salle blanche et de type « front-end », par exemple tel que du Ni ou du Ti. La couche métallique 17 peut être prévue avec une épaisseur comprise par exemple entre 5 et 30 nm.

Dans l'exemple de réalisation particulier illustré sur la figure 1C, la couche métallique 17 est elle-même revêtue d'une autre couche métallique 18 de protection en un matériau dit « oxydorésistant », c'est-à-dire réfractaire à l'oxydation tel que par exemple du TiN. L'autre couche métallique 18 peut être prévue avec une épaisseur minimale par exemple d'au moins 5 nm dans l'exemple particulier du TiN formé sur du Ti. Par exemple, l'autre couche métallique 18 peut avoir une épaisseur de l'ordre de 10 nm.

Le dépôt de cet empilement de couches métalliques 17, 18 peut être par exemple réalisé au moyen d'un procédé de dépôt physique en phase vapeur (PVD pour « physical vapor déposition ») ou d'un procédé de dépôt chimique en phase vapeur (CVD, pour « chemical vapor deposition »).

L'endommagement de la structure cristalline de la région supérieure 142 de la couche semi-conductrice 14 réalisée précédemment permet notamment d'abaisser les barrières de nucléation associées à des réactions à l'état solide qui seront mises en œuvre par la suite pour former un alliage de métal et de semi-conducteur. On forme de cette manière l'alliage à plus basse température afin notamment de ne pas détériorer la structure sous-jacente et/ou des composants déjà formés, par exemple des diodes ou des transistors (non représentés).

Ainsi, un traitement thermique de recuit à une température typiquement comprise entre 400°C et 800°C et ici avantageusement inférieure à 600°C est ensuite effectué pour initier la réaction entre le matériau semi-conducteur de la couche semi-conductrice 14 et le métal de la couche métallique 17.

Le recuit peut être un traitement thermique dit « rapide », de type RTA (pour « Rapid Thermal Anneal ») mis en œuvre dans une chambre de recuit équipée avec des lampes chauffantes, en particulier des lampes halogènes ou à arc. Un tel recuit est effectué de préférence sous atmosphère inerte, par exemple de N₂ ou d'Ar.

La durée de ce recuit peut être comprise par exemple entre 15 s et 5 min, avantageusement entre 30 s et 3 min en particulier lorsque la température de recuit est comprise entre 400 °C et 600 °C.

Au cours du recuit, un processus d'inter-diffusion entre les atomes de la couche semi-conductrice 14 et ceux de la couche métallique 17 est mis en œuvre pour créer un alliage de métal et de semi-conducteur. Dans le cas d'une couche métallique 17 en Ti, et d'une couche semi-conductrice 14 en GaN, les atomes de Ti migrent dans la région superficielle 142 rendue amorphe ou quasi-amorphe de la couche semi-conductrice 14. La région superficielle 142 est prévue suffisamment fine pour être entièrement consommée par le front de croissance de la phase d'intérêt.

A l'issue du recuit dans les conditions susvisées, on obtient une zone 159 d'alliage de métal et de semi-conducteur, par exemple en Ti₁₋ₓGaₓ(N), formée à partir du métal de la couche métallique 17, ici du Ti, et le semi-conducteur à base de GaN.

Les inventeurs ont découvert, que dans des conditions de procédé précitées, la réaction entre la région 142 fortement endommagée de la couche semi-conductrice 14 et le matériau de la première couche métallique tendait à repousser les atomes implantés dans la couche semi-conductrice 14 à l'interface entre la couche d'alliage semi-conducteur/métal obtenu après recuit et la structure cristalline sous-jacente, préservée lors de l'étape d'implantation et atteinte par le front de croissance lors du recuit.

On obtient ainsi une fine couche 158 où sont ségrégés l'ensemble des atomes implantés, encore appelée « couche delta » ou couche δ (δ-layer ou « delta-layer » selon la terminologie anglosaxonne) comportant les atomes de l'espèce dopante, ici de Mg, en contact avec la région inférieure 141 cristalline de la couche semi-conductrice 14.

La fine couche 158 peut être composée d'au moins 5 % d'atomes de Mg, typiquement d'au moins 20%, sur une épaisseur allant de moins d'un nanomètre à plusieurs dizaines de nanomètres, typiquement de 5 nm à 10 nm.

Une telle couche atomique 158 en contact avec la région inférieure 141 cristalline de la couche semi-conductrice 14 permet d'améliorer la qualité du contact ohmique obtenu sur la région semi-conductrice cristalline 141 à base de GaN.

Un procédé tel que décrit précédemment s'intègre dans une partie communément appelée de « front-end » d'un dispositif microélectronique ou circuit intégré, autrement dit une séquence d'étapes effectuées au début ou en amont de la réalisation de ce dispositif ou de ce circuit, et durant laquelle on forme notamment différents composants tels que des transistors et/ou des diodes dans au moins une couche semi-conductrice.

Une structure de contact ohmique dont la réalisation vient d'être décrite peut être intégrée dans différents types de composants ou pour contacter différents types de composants électroniques, en particulier de type transistor ou diode. Une telle structure peut être prévue par exemple pour une diode JBS (pour « Junction Barrier Schottky », i.e. une Diode Schottky à Barrière de Jonction), ou un transistor MOS et en particulier de type pMOS, ou un transistor HEMT (« High Electron Mobility Transistor », i.e. « Transistor à Haute Mobilité Électronique »).

## Revendications

1. Procédé de réalisation d'un contact ohmique sur une couche semi-conductrice (14) à base de GaN et dopée p comprenant, dans cet ordre, les étapes suivantes :
- prévoir un substrat (10) revêtu par la couche semi-conductrice à base de nitrure de gallium (GaN) (14),
- effectuer au moins une implantation de la couche semi-conductrice (14) à l'aide de Magnésium (Mg) de sorte à endommager la structure cristalline d'une région superficielle (142) de la couche semi-conductrice (14) et à introduire des atomes de Mg dans ladite région superficielle,
- déposer une première couche métallique (17) sur et en contact de la région superficielle (142) endommagée de la couche semi-conductrice (14),
- effectuer au moins un traitement thermique de recuit selon une température et une durée de recuit prévues de manière à faire réagir la région superficielle (142) et la première couche métallique (17) pour former dans cette région superficielle une zone d'alliage de métal et de semi-conducteur et former entre cette zone d'alliage de métal et de semi-conducteur et la région inférieure cristalline de la couche semi-conductrice une fine couche d'épaisseur comprise entre 5 nm et 10 nm et comportant une concentration en atomes de Magnésium supérieure 5% et typiquement supérieure à 20%.

2. Procédé selon la revendication 1, dans lequel l'implantation de la couche semi-conductrice (14) est effectuée à une dose élevée et en particulier supérieure à 1E16 atomes/cm² avec une énergie faible et en particulier inférieure à 4 keV.

3. Procédé selon l'une des revendications précédentes, dans lequel la région superficielle (142) par ladite implantation a une épaisseur comprise entre 3 nm et 10 nm.

4. Procédé selon l'une des revendications précédentes, dans lequel la température de recuit est comprise entre 400°C et 600°C.

5. Procédé selon la revendication 4, dans lequel la durée du recuit est prévue entre 15 s et 30 min, avantageusement entre 30s et 3 min.

6. Procédé selon l'une des revendications précédentes, dans lequel la première couche métallique est une couche de Ti.

7. Procédé selon l'une des revendications précédentes, dans lequel la première couche métallique est revêtue d'une autre couche métallique d'encapsulation, en particulier à base d'un métal oxydorésistant tel que du TiN.

8. Procédé selon l'une des revendications précédentes, dans lequel la première couche métallique a une épaisseur comprise entre 5 nm et 30 nm.

9. Procédé selon l'une des revendications précédentes, dans lequel la couche semi-conductrice (14) est formée d'un ou plusieurs des matériaux suivants : GaN ou d'AlGaN, ou d'InGaN.
